# EUROPÄISCHE PATENTSCHRIFT

(11) **EP 0 892 090 B1**
(45) Veröffentlichungstag und Bekanntmachung des Hinweises auf die Patenterteilung: **23.04.2008**
(21) Anmeldenummer: 98810105.1
(22) Anmeldetag: 11.02.1998
(51) Int. Cl.: C30B 11/00

(54) **Verfahren zum Herstellen von einkristallinen Strukturen**
Method for manufacturing single crystal structures
Procédé de fabrication de structure monocristallines

(30) Priorität: 24.02.1997 EP 97810091
(43) Veröffentlichungstag der Anmeldung: 20.01.1999
(60) Teilanmeldung: 02020130.7
(73) Patentinhaber: SULZER INNOTEC AG, CH-8401 Winterthur (CH)
(72) Erfinder: Kurz, Wilfried, 1025 St. Sulpice (CH); Gäumann, Matthias, 1110 Morges (CH); Bieler, Hans-Werner, 8404 Winterthur (CH); Wagnière, Jean-Daniel, 1004 Lausanne (CH); Rusterholz, Hansjakob, 8400 Winterthur (CH)
(74) Vertreter: Sulzer Management AG

(56) Entgegenhaltungen:
- EP-A- 0 740 977
- DEXIN MA ET AL: "EINKRISTALLERSTARRUNG DER NI-BASIS-SUPERLEGIERUNG SRR 99" ZEITSCHRIFT FUR METALLKUNDE, Bd. 82, Nr. 11, 1.November 1991, Seiten 869-873, XP000278142

## Beschreibung

Die Erfindung bezieht sich auf ein epitaktisches Verfahren zum schichtweisen Ergänzen von einkristallinen Strukturen, Teilen oder Werkstücken, aus metallischen Superlegierungen und mit einkristalliner Strucktur oder einkristallinen Strukturen nach dem Oberbegriff des unabhängigen Anspruchs 1.

Metallische Werkstücke mit einkristalliner Struktur werden als Teile von Maschinen verwendet, die im Betrieb hohen mechanischen, thermischen und/oder chemischen Belastungen ausgesetzt sind. Beispielsweise werden Schaufeln von Gasturbinen, insbesondere auch von Rotoren für Flugzeug-Triebwerke, aber auch solche für stationäre Gasturbinen, aus Einkristallen hergestellt. Die Fertigung von derartigen einkristallinen Werkstücken erfolgt z.B. durch gerichtetes Erstarren aus der Schmelze. Es handelt sich dabei um Giessverfahren, bei denen die flüssige metallische Legierung zur einkristallinen Struktur, d.h. zum einkristallinen Werkstück erstarrt.

Es ist beispielsweise ein spezielles Giessverfahren zum Herstellen derartiger Werkstücke bekannt, bei dem die in einer keramischen Form befindliche flüssige Legierung in einem gerichteten Temperaturfeld, z.B. eines Bridgmanofens, eine Kristallorientierung erhält. Dabei werden die dendritischen Kristalle entlang dem Wärmefluss ausgerichtet und bilden entweder eine stengelkristalline Kornstruktur (d.h. Körner, die über die ganze Länge des Werkstückes verlaufen und hier, dem allgemeinen Sprachgebrauch nach, als "gerichtet erstarrt" bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da dieses ungerichtete Wachstum notwendigerweise transversale und longitudinale Korngrenzen ausbildet, welche die guten Eigenschaften des gerichtet erstarrten oder einkristallinen Bauteiles zunichte machen.

EP-A-0 740.977 beschreibt ein Verfahren zum Herstellen von rissfreien metallischen Gegenständen. Mit einem Laserstrahl mit relativ niedriger Energiedichte relativ grossem Durchmesser des Strahls, wird auf dem Substrat ein Bad mit niedrigem Verhältnis von Tiefe zu Durchmesser (aspect ratio) erzeugt.

Wenn in der vorliegenden Schrift von einkristalliner Struktur und einkristallinen Strukturen die Rede ist, so sind damit sowohl Einkristalle, die keine Korngrenzen aufweisen, als auch Kristallstrukturen, die wohl Korngrenzen die longitudinal verlaufen, aber keine Korngrenzen, die in transversaler Richtung verlaufen, aufweisen. Bei diesen zweitgenannten kristallinen Strukturen spricht man auch von gerichtet erstarrten Gefügen (directionally solidified structures).

Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stengelkristallstrukturen, die wohl in longitudinaler Richtung verlaufende Korngrenzen, aber keine transversalen Korngrenzen aufweisen.

Als Legierungen beispielsweise für die erwähnten Einkristall-Turbinenschaufeln, werden u.a. sog.

Superlegierungen auf Nickel- (Ni), Kobalt- (Co) oder Eisenbasis (Fe) verwendet. Besonders Superlegierungen auf Nickelbasis haben hervorragende mechanische und chemische Hochtemperatureigenschaften.

Aufgabe der Erfindung ist es, ein Verfahren zu schaffen, mit welchem es möglich ist, auf der einkristallinen Struktur eines Substrats einen Körper bzw. ein Werkstück mit ebenfalls einkristalliner Struktur aufzubauen. Nach der Erfindung ist das Verfahren durch die Merkmale des unabhängigen Anspruchs 1 gekennzeichnet. Die abhängigen Ansprüche beziehen sich auf vorteilhafte Ausführungsformen der Erfindung.

Mit dem neuartigen Verfahren ist es möglich, auf der beispielsweise gerichtet erstarrten Struktur eines Substrats eine oder mehrere Schichten, bzw. einen Körper oder ein Werkstück mit der gleichen gerichtet erstarrten Struktur wie das Substrat aufzubauen. Es handelt sich um ein epitaktisches Verfahren (epitaktisch nennt man das gleichorientierte Kristallwachstum auf einer kristallinen Unterlage), bei welchem die gerichtete kristalline Struktur des Substrates, von der Schicht oder den Schichten, die aufgebaut werden, übernommen wird. Dabei muss durch eine entsprechende Prozesskontrolle ein globulitisches Gefüge vermieden werden.

Die Erfindung schafft ein neuartiges Verfahren, mit dem es möglich ist, auf einem Substrat mit einkristalliner Struktur, bzw. einkristallinen Strukturen eine oder mehrere Schichten, bzw. einen Körper oder ein Werkstück mit einkristalliner Struktur aufzubauen. Es handelt sich dabei um ein epitaktisches Verfahren, bei welchem die kristalline Struktur des Substrates von der Schicht oder den Schichten, die aufgebaut werden, übernommen wird.

Bisher gab es keine Möglichkeit, ein einkristallines Werkstück so zu reparieren bzw. zu rekonditionieren, dass das einkristalline Gefüge des Grundwerkstoffes auch in der rekonditionierten Stelle vorliegt. Mit dem neuen Verfahren ist es nun möglich, beschädigte und abgenutzte, einkristalline Werkstücke einkristallin zu rekonditionieren, d.h. die optimale Kristallstruktur zu ergänzen und neu aufzubauen. Dabei wird auf dem Substrat, bei z.B. einer einkristallinen Rotorschaufel Schicht um Schicht einkristallin auf- und weitergebaut bis die ursprüngliche Grösse und Form des Werkstücks wieder erreicht ist.

Das Verfahren für den Aufbau von Einkristallen aus dem gleichen Werkstoff, angenähert gleichen oder verschiedenen Werkstoffen wie das Substrat, ermöglicht beispielsweise den Neuaufbau bzw. die Ergänzung von Werkstücken, die einkristalline Strukturen aufweisen und die beschädigt sind oder abgenutzt sind. Beispielsweise gibt es heute Rotorschaufeln von Gasturbinen, die aus Einkristallen von sog. metallischen Superlegierungen bestehen und die mit dem Verfahren repariert werden können wenn sie beschädigt sind.

Einkristalline Werkstücke können zwar aus der Schmelze durch sog. gerichtetes Erstarren (directionally solidified) hergestellt werden. Aber auch solche mit gerichtetem Erstarren hergestellte Teile nützen sich ab. Bisher gibt es aber keine Möglichkeit, ein derartiges Werkstücke einkristallin oder gerichtet erstarrt zu reparieren /rekonditionieren, d.h. das einkristalline Gefüge eines abgenutzten Werkstücks wieder einkristallin aufzubauen. Mit dem neuen Verfahren ist es nun auch möglich, beschädigte und abgenutzte, einkristalline Werkstücke einkristallin zu rekonditionieren, d.h. die Kristallstruktur zu ergänzen und neu aufzubauen. Dabei wird auf dem Substrat, bei z.B. einer einkristallinen Rotorschaufel Schicht um Schicht einkristallin auf- und weitergebaut bis die ursprüngliche Grösse und Form des Werkstücks wieder erreicht ist.

Als Energie- bzw. Wärmequelle für das Durchführen des Verfahrens werden Laserstrahlen verwendet mit denen es möglich ist, auf eine sehr kleine Fläche, bzw. in ein kleines Volumen hohe Energiemengen konzentriert einzubringen.

Der Laserstrahl hoher Energie und Energiedichte wird auf die Oberfläche des Substrats gerichtet, so dass die Oberflächenschicht des Substrats leicht anschmilzt. Dem Arbeitsbereich des Strahls wird das Material in Pulverform oder in Form eines Drahts zugeführt. Das zugeführte Material wird ebenfalls geschmolzen. Das Schmelzen dieses zugeführten Materials kann im Flüssigbad der geschmolzenen Oberflächenschicht oder schon auf dem Weg zum Flüssigbad erfolgen. Der Vorgang läuft vorzugsweise unter Schutzgas und/oder im Vakuum ab.

Wenn nun das Erstarren der Schmelze unter Bedingungen abläuft, die ausserhalb des globulitischen Bereichs, also im Bereich, in welchem das verwendete Material gerichtet erstarrt liegt, erstarrt der Werkstoff in einkristalliner Form, wächst also als epitaktische Struktur auf dem Substrat. Bei Metallen spricht man von globulitischer Erstarrung, wenn dieses nicht gerichtet kristallisiert. Es bilden sich dann beim Übergang von gerichtet einkristallin auf ungerichtet notwendigerweise eine oder mehrere Korngrenzen aus, welche die Vorteile des Einkristalls zunichte machen.

Die einkristalline Struktur wird in Form von dünnen Schichten, Platten oder komplexen Formen von etwa einem Millimeter oder einem Bruchteil eines Millimeters übereinander, Schicht für Schicht aufgetragen.

Wenn das Substrat z.B. induktiv auf eine Vorwärmtemperatur im Bereich von 750°C bis 1100°C, gebracht wird und diese Temperatur z.B. während dem Aufbau aufrecht erhalten wird, werden die Spannungen im Substrat und im aufgebauten Einkristall, aber auch zwischen dem Substrat und der epitaktisch darauf aufgebauten kristallinen Struktur verringert, was zum Verhindern von Rekristallisation und Kriechen in der Kristallstruktur beiträgt.

Entspannungsglühen von Substrat und neu aufgebauter Einkristallschicht während etwa einer Stunde bei einer Temperatur im Bereich von etwa 1000°C bis 1250°C, für CMSX-4 bei ca. 1150°C und nachfolgendem langsamem abkühlen reduziert innere Spannungen, welche zur Zerstörung der einkristallinen Strukturen durch Rekristallisation und Kriechen führen könnten. Das Spannungsarmglühen könnte aber auch gleich nach dem Aufbringen der epitaktischen Schicht mit einer HF-Einrichtung erfolgen.

Das Verfahren wird nachstehend anhand von Ausführungsbeispielen des Verfahrens näher erläutert. Die Figuren dienen zur Erläuterung von wesentlichen Parametern des Verfahrens und zeigen schematisch eine Laservorrichtung, welche für das Durchführen des Verfahrens geeignet ist. Es zeigt:
- Fig. 1: das Temperaturgradient- (G) /Erstarrungsgeschwindigkeits-(V) Diagramm in doppeltlogarithmischer Darstellung, das sog. GV-Diagramm (GV für "gradient velocity" bzw. "Temperaturgradient /Erstarrungsgeschwindigkeit");
- Fig. 2 A und B: den kristallinen Aufbau eines nach dem Verfahren der Erfindung aufgebauten und rekonditionierten Werkstückes;
- Fig. 3: schematisch eine Einrichtung, die bei der Durchführung des Verfahrens geeignet ist.
- Fig. 4: zeigt schematisch den Prozess des Aufbringens einer Spur auf den Grundwerkstoff durch Einblasen von Pulver in das vom Hochenergiestrahl gebildete Schmelzbad.

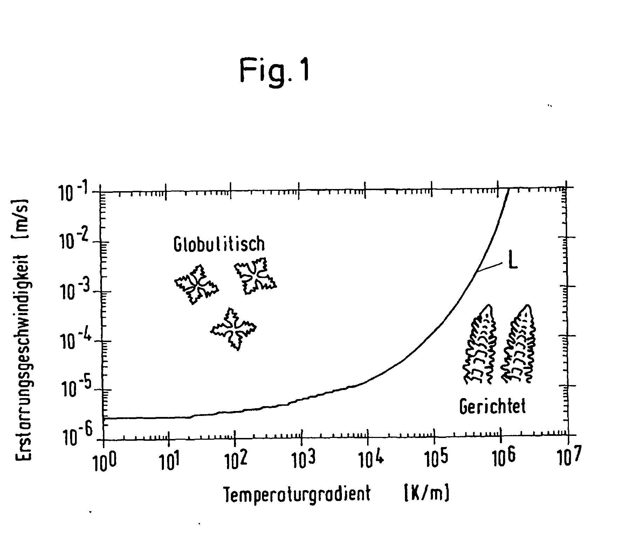

Die Fig. 1 zeigt das typische GV-Diagramm einer Superlegierung wie es z.B. für CMSX-4, einer Superlegierung auf Nickelbasis welche folgende Zusammensetzung in Gewichtsprozent hat:
C < 0.006; Cr 6.5; Co 9.7; Mo 0.6; W 6.4; Ti 1.0; Al 5.6; Ta 6.5; Re 3.0; Hf 0.09; Rest Ni.

Das GV-Diagramm ist für verschiede Metalle und metallische Legierungen unterschiedlich und kann für jede Legierung berechnet oder experimentell bestimmt werden. Die Kurve L trennt das GV-Diagramm den Bereich der beiden Parameter Erstarrungsgeschwindigkeit und Temperaturgradient in welchem die Legierung globulitisch erstarrt von jenem in welchem die Legierung zu einem dendritisch gerichteten Gefüge erstarrt. Eine Beschreibung und Erklärung des GV-Diagramms findet sich z.B. in Material Science Engineering Band 65 1984, in der Publikation J. D. Hunt über "Columnar to Equiangular Transition"

Beim Durchführen des Verfahrens mit einem Laser sollte bei einer Erstarrungsgeschwindigkeit von 10⁻³m/s der Temperaturgradient grösser als 4x10⁵ °K/m betragen, damit nach der Erfindung auf dem Substrat eine einkristalline Struktur epitaktisch aufwachsen kann (Epitaxie nennt man das orientierte Kristallwachstum auf einer kristallinen Unterlage, d.h. einer kristallinen Struktur).

Für das Verfahren heisst dies, dass z.B. der Laserstrahl mit einer Geschwindigkeit von etwa 10⁻³ m/s über das Substrat geführt werden muss, wenn die Energiezufuhr mit dem Laserstrahl so gewählt ist, dass an der Erstarrungsfront ein Temperaturgradient von grösser als 6x10⁵ °K/m aufrecht erhalten wird.

Oder es heisst für das Verfahren auch, dass z.B. der Laserstrahl mit einer Geschwindigkeit von etwa 10⁻³ m/s über das Substrat geführt werden muss, wenn die Energiezufuhr mit dem Laserstrahl so gewählt ist, dass zwischen dem Arbeitspunkt (der Punkt bzw. Bereich wo der Laserstrahl auf dem Flüssigbad auftrifft) im Flüssigbad und der Erstarrungsfront der Temperaturgradient im Bereich der Phasengrenze fest/flüssig in der Schmelze, von 6x10⁵ °K/m aufrecht erhalten wird.

In der Praxis wird die Geschwindigkeit, mit welcher der Laserstrahl über das Substrat geführt wird, im Bereich von 0.001 m/sec und 0.1 m/sec liegen. Entsprechend dem GV-Diagramm für die gewählte Legierung, muss die Energie des Laserstrahls so eingestellt werden, dass der Temperaturgradient vom Arbeitspunkt zur Erstarrungsgrenze bzw. zur wandernden Erstarrungsfront, je nach gewählter Geschwindigkeit, grösser als 10⁶ °K/m ist.

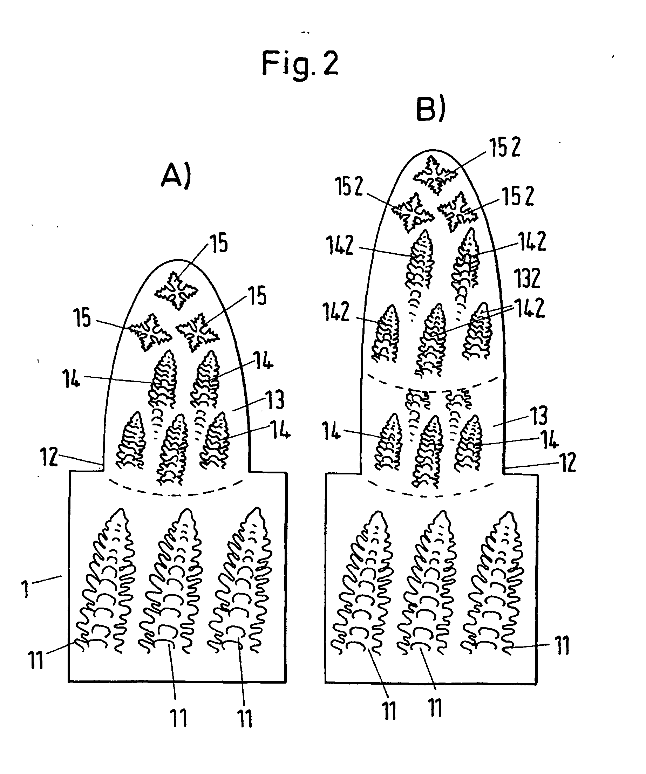

Wie in Fig. 2 A und B gezeigt, weist das Substrat 1 eine monokristalline, dendritische Struktur mit den Dendriten 11 auf. Alle Dendriten sind entlang der drei Raumachsen gleich orientiert. In Fig. 2A ist eine erste, auf dem Substrat nach dem Verfahren hergestellte, monokristalline, epitaktische Schicht schematisch dargestellt. Fig. 2B zeigt schematisch eine solche Struktur, die aus zwei Schichten aufgebaut ist. Der Aufbau der monokristallinen Struktur erfolgt in gleicher Weise durch Aufeinanderschichten einer beliebigen Zahl weiterer epitaktischer Schichten.

Diese Struktur wird an der Oberfläche mit dem Laserstrahl auf- und umgeschmolzen; dem flüssigen, geschmolzenen Bad wird das Material z.B. als Draht oder Pulver zugeführt (nicht gezeigt). Das zugeführte Material, das eine mono- oder polykristalline Struktur haben kann, wird in das aufgeschmolzenen Grundmaterial in der Umschmelzzone 12 eingebracht und vollständig geschmolzen. Dieses zugeführte Material, also z.B. das geschmolzene Pulver, erstarrt dann zu einer Schicht 13 zu einem dendritische Einkristall bzw. zu einem einkristallinen Gefüge mit einkristallinen Dendriten, d.h. zu einem dendritischen Einkristall 14. Im oberen Grenzbereich bilden sich auf Grund der thermischen Bedingungen und/oder nicht ganz aufgeschmolzenen Pulverteilchen meist sog. Globuliten 15, welche die monokristalline Struktur stören können indem sie als Nukleus für einen Dendriten dienen könnten, der die monokristalline Struktur stört.

Beim Aufbringen der zweiten epitaktischen Schicht 132, werden die globulitischen Dendriten wieder auf- und umgeschmolzen und erstarren in Form von gerichteten Dendriten 142, d.h. als Einkristalle. Auch auf dieser zweiten epitaktischen Schicht 132 bilden sich auf der Oberfläche wieder globulitische Dendriten.

Einkristalline Strukturen können mit dem Verfahren der Erfindung beispielsweise mit CMSX-4 bei folgenden Bedingungen auf einem einkristallinen Substrat aus CMSX-4 aufgebaut werden:

| | |
|---|---|
| Lasertyp: | 1.5 kW CO₂ Laser |
| Durchmesser Laserspot: | 2.5 mm (Durchmesser des Laserstrahls auf dem Substrat bzw. der vorangehenden Schicht) |
| Pulver: | CMSX-4 Pulver mit einer Partikelgrösse (mesh) im Bereich von etwa 40 - 70 µm Durchmesser |
| Substrat: | CMSX-4 Einkristall |
| Schutzgas: | Argon (Ar); 35 Liter/min |

Bei der ersten Schicht (Spur) auf dem Substrat:

| | |
|---|---|
| Leistung Laser: | ca. 900 W |
| Geschwindigkeit Laserspot auf dem Substrat: | ca. 4.2 mm/sec (250 mm/Min) |

| | |
|---|---|
| Bei der zweiten Schicht (Spur): Rückzug (Offset) Pulverspritzdüse und des Laserstrahls entlang der optischen Achse, bzw. hinter das Schmelzbad, relativ zur Verfahrensrichtung: (für zweite Schicht) | ca. 100 µm |
| Leistung Laser: | ca. 600 W |
| Geschwindigkeit Laserspot auf dem Substrat: | ca. 500 mm/Min (8.4 mm/sec) |
| Dritte und weitere Schichten (Spuren): Rückzug (Offset) Pulverspritzdüse hinter das Schmelzbad, relativ zur Verfahrensrichtung: | ca. 70 µm |
| Leistung Laser: | ca. 600 W |
| Geschwindigkeit Laserspot auf dem Substrat: | ca. 750 mm/Min |

Die erste Schicht wird auf das monokristalline Substrat aufgebracht; die zweite Schicht auf die epitaktisch erzeugte erste Schicht u.s.w. immer die nächstfolgende Schicht auf die vorhergehende.

Es ist zu beachten, dass das Wachsen einer monokristallinen Schicht voraussetzt, dass das zugeführte Material vollständig aufgeschmolzen wird. Wenn dies nicht der Fall ist, bilden z.B. nicht vollständig geschmolzene Pulverkörner Kristallisationskerne für Dendriten und Kristalle, welche das einkristalline Wachstum der Struktur stören und zerstören.

Beim Aufbau einer grösseren Struktur, bzw. eines grösseren Körpers mit dem epitaktischen Verfahren, bilden sich an der Oberfläche der zuletzt hergestellten Schicht globulitische Bezirke. Diese "equiaxed grains" sind Keime, welche das gerichtete Wachstum der Kristalle stören oder unterbrechen.

Beim Aufbau der nächsten, darüberliegenden Schicht ist es demnach von grosser Wichtigkeit, dass diese Globuliten vollständig aufgeschmolzen werden, so dass Dendriten, welche das monokristalline Gefüge zerstören würden verschwinden, bzw. unter der Oberfläche gar nicht entstehen.

Anderer Superlegierungen, mit denen sich nach dem Verfahren der vorliegenden Erfindung einkristalline Strukturen aufbauen lassen, sind beispielsweise IN 738LC, IN 939, IN 100, B 1914, CM 99, SRR 99,
CM-247 LC, CMSX-2, CMSX-3, CMSX-6, Mar-M002

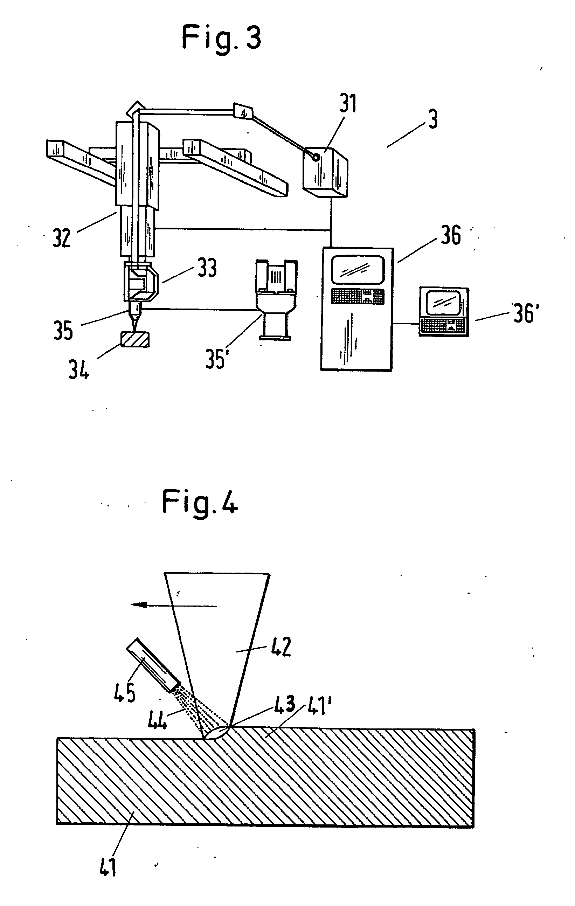

Die in Fig. 3 schematisch gezeigte Anlage 3 zum Durchführen des Verfahrens umfasst den Laser, z.B. einen CO₂ -Laser 31. Der Strahl des Lasers 31 wird zum CNC-gesteuerten Strahlführungssystem 32 mit der Laserstrahl-Fokussieroptik 33 gelenkt und gelangt dann auf das Substrat bzw. Werkstück 34, auf welchem die kristalline Struktur aufgebaut werden soll. Die CNC-Anlage 36 welche den Prozess steuert und regelt, kann am Programmierplatz 36' programmiert werden. Der Pulverförderer 35' bringt das Material zum Beschichtungsmodul 35 und von dort wird das beispielsweise pulverförmige Material zum Schmelzbad auf dem Substrat 34 geführt/geblasen, wo das Material vorerst vollständig geschmolzen wird und dann zur einkristallinen Struktur erstarrt. Mit dem Beschichtungsmodul 35 kann auch der Schutzgasmantel erzeugt werden.

Fig. 4 schliesslich zeigt schematisch das z.B. einkristalline Substrat 41. Der Laserstrahl 42 schmilzt die Oberfläche des Substrats 4lan. Es bildet sich das Schmelzbad 43, in welches das pulverförmige Material 44 von der Pulverdüse 45 zum Schmelzbad 43 geblasen wird. Der Laserstrahl und damit auch das Schmelzbad 43, eine Schmelzzone, bewegt sich in Richtung des Pfeils. Das Schmelzbad erstarrt zur epitaktischen Schicht 41, welche die kristalline Struktur des Substrats 41 aufweist.

Das Verfahren mit einem Laser als Energiequelle könnte im Vakuum durchgeführt werden. Im Vakuum ist zwar kein Schutzgas erforderlich, dafür kann das Manipulieren von Energiequelle, Substrat und zuzuführendem Werkstoff Probleme bringen. Darüber hinaus sind geeignete Vakuumkammern in der Regel nicht in beliebiger Grösse verfügbar.

Beim Verfahren zum Herstellen von einkristallinen Strukturen, Teilen oder Werkstücken aus metallischen Superlegierungen, auf Substraten mit einkristalliner Struktur oder einkristallinen Strukturen, wird mit einem Laserstrahl hoher Energiedichte von einer Energiequelle, die Oberfläche des Substrats aufgeschmolzen. Dem geschmolzenen Bereich des Substrates wird das Material zugeführt, das in die einkristalline Struktur gebracht werden soll. Das zugeführte Material wird vollständig aufgeschmolzen. Die Energiezufuhr mit dem Laserstrahl wird so geregelt und/oder gesteuert, dass Erstarrungsgeschwindigkeit und Temperaturgradient im GV-Diagramm im gerichtet erstarrten, dendritischen, d.h. im dendritisch kristallinen Bereich, ausserhalb des globulitischen Bereichs liegen.

## Patentansprüche

1. Epitaktisches Verfahren zum schichtweisen Ergänzen von einkristallinen Strukturen, Teilen oder Werkstücken aus metallischen Superlegierungen und mit einkristalliner Struktur oder einkristallinen Strukturen **dadurch gekennzeichnet, dass**
mit einem Laserstrahl hoher Energiedichte ein Bereich der Oberfläche der einkristallinen Struktur, des einkristallinen Teils oder Werkstücks aufgeschmolzen wird,
dem geschmolzenen Bereich das Material zugeführt wird, das zum Ergänzen in die einkristalline Struktur gebracht werden soll,
das zugeführte Material vollständig aufgeschmolzen wird und
die Energiezufuhr so geregelt und/oder gesteuert wird, dass
der Temperaturgradient vom Arbeitspunkt zur Erstarrungsgrenze grösser als 10⁶ °K/m ist, und der Laserstrahl mit einer Geschwindigkeit im Bereich von 10⁻³ bis 10⁻¹ m/sec über die Strukturen, die Teile oder die Werkstücke geführt wird,
oder
der Temperaturgradient vom Arbeitspunkt zur Erstarrungsgrenze grösser als 4 x 10⁵ °K/m ist und der Laserstrahl mit einer Geschwindigkeit von 10⁻³ m/sec über die Strukturen, die Teile oder die Werkstücke geführt wird, so dass Erstarrungsgeschwindigkeit und Temperaturgradient vom Arbeitspunkt zur Erstarrungsgrenze im GV-Diagramm im dendritisch kristallinen Bereich, ausserhalb des globulitischen Bereichs des Materials liegen.

2. Epitaktisches Verfahren nach Anspruch 1, bei welchem das Material, das in die einkristalline Struktur gebracht werden soll, in Pulverform oder in der Form eines Drahtes zugeführt wird.

3. Epitaktisches Verfahren nach Anspruch 1 oder 2, bei welchem das zugeführte Material gleich ist wie jenes der einkristallinen Struktur, des einkristallinen Teils oder Werkstücks oder
bei welchem das zugeführte Material verschieden ist und eine ähnliche Kristallstruktur wie das Material des Substrats aufweist.

4. Epitaktisches Verfahren nach einem der Ansprüche 1 bis 3, bei welchem das Material der einkristalline Struktur, des einkristallinen Teils oder Werkstücks und/oder das Material, das in eine einkristalline Struktur gebracht werden soll, eine metallische Superlegierung auf Co-Basis, oder auf Fe-Basis oder auf Ni-Basis, wie CMSX-4 ist.

5. Epitaktisches Verfahren nach einem der Ansprüche 1 bis 4, bei welchem die einkristalline Struktur, das einkristalline Teil oder Werkstück auf eine Vorwärmtemperatur, vorzugsweise im Temperaturbereich von 800°C bis 1000°C vorgewärmt wird, wobei die Vorwärmtemperatur während des Ergänzens der epitaktischen Schicht vorzugsweise konstant erhalten wird.

6. Epitaktisches Verfahren nach Anspruch 5, bei welchem das Vorwärmen der einkristallinen Struktur, des einkristallinen Teils oder Werkstücks induktiv erfolgt.

7. Epitaktisches Verfahren nach einem der Ansprüche 1 bis 6, bei welchem die hergestellte kristalline Struktur nachfolgend, spannungsarmgeglüht wird.

8. Epitaktisches Verfahren nach einem der Ansprüche 1 bis 7, das unter Schutzgas oder im Vakuum durchgeführt wird, wobei das Schutzgas im Verfahrensbereich vorzugsweise laminar oder weitgehend laminar fliesst.

9. Epitaktisches Verfahren nach einem der Ansprüche 1 bis 8 zum Ergänzen der einkristallinen Struktur einer abgenutzten einkristallinen Turbinenschaufel einer Gasturbine oder eines Flugzeugtriebwerks.

## Claims

1. Epitaxial method to complete in layers monocrystalline structures, parts or work pieces of metallic super-alloys on substrates with a monocrystalline structure or monocrystalline structures **characterized in that**
the surface of the substrate is melted with a laser beam of high energy density an area of the monocrystalline structure, of the monocrystalline work piece is molten,
the material to be brought into the monocrystalline structure is supplied to the molten region,
the supplied material is completely melted and
the energy input is regulated and/or controlled in such a manner that temperature gradient between the working point and the solidification area is equal or more than 10⁶°K and
that the laser beam is guided over the structure, the parts of the work pieces with a speed in the range between 10⁻³ m/sec and 0.1 m/sec
or
that the temperature gradient between the working point and the solidification area is equal of greater than 4 x 10⁵°K/m and
that the laser beam is guided over the structure, the parts or the work pieces with a speed of 10⁻³ m/sec and
the rate of solidification and the temperature gradient at the working point lie in the dendritic crystalline region in the GV-diagram, and outside the globulitic region.

2. Epitaxial method in accordance with claim 1, in which the material which is to be brought into the monocrystalline structure is supplied in powder form or in the form of a wire.

3. Epitaxial method in accordance with claim 1 or 2 in which
the supplied material is the same as that of the monocrystalline structure, the monocrystalline part or work piece or
in which the supplied material is different and has a crystalline structure similar to that of the substrate.

4. Epitaxial method in accordance with one of the claims 1 to 3 in which the monocrystalline structure, the monocrystalline part or work piece and/or the material which is to be introduced into a monocrystalline structure is a metallic super-alloy on a Co basis or on a Fe basis or on a Ni basis, such as CMSX-4.

5. Epitaxial method in accordance with one of the claims 1 to 4 in which the monocrystalline structure, the monocrystalline part or work piece is preheated to a preheating temperature, preferably in the temperature range from 800°C to 1000°C, with the preheating temperature preferably being held constant during the production of the epitaxial layer.

6. Epitaxial method in accordance with claim 5 in which the preheating of the monocrystalline structure, the monocrystalline part or work piece is carried out inductively.

7. Epitaxial method in accordance with one of the claims 1 to 6 in which the manufactured crystalline structure is heated as to reduce stress.

8. Epitaxial method in accordance with one of the claims 1 to 7 which is carried out under protective gas or in a vacuum, with the protective gas preferably flowing laminarly or largely laminarly in the region of the process.

9. Epitaxial method in accordance with one of the claims 1 to 8 for supplementing the monocrystalline structure of a worn monocrystalline turbine blade, in particular of the rotor blade of a gas turbine or of an aeroplane engine.

## Revendications

1. Procédé épitaxial pour compléter avec des couches sur des structures monocristallines, des éléments, ou des pièces d'usinage en superalliages métalliques, **caractérisés par**
un rayon laser de haute densité d'énergie, avec lequel un secteur de la surface des structures monocristallines, des éléments, ou des pièces d'usinage est fondue,
l'alimentation du secteur fondu avec le matériel qui doit être mis dans la structure monocristalline,
le fait que le matériel alimenté est fondu complètement et
l'approvisionnement d'énergie réglé et/ou commandé de telle façon que le gradient de température du point de travail au front de solidification, respectivement du point de travail bougeant au front de solidification bougeant est égale à ou plus grand que 10⁶ °K/m, et
que le rayon laser est conduit sur le substrat avec une vitesse entre 10⁻³ m/sec à 10⁻¹ m/sec,
ou
que le gradient de température du point de travail au front de solidification, respectivement du point de travail bougeant au front de solidification bougeant est égale à ou plus grand que 4 X 10⁵ °K/m, et
que le rayon laser est conduit sur les structures monocristallines, les éléments, ou les pièces d'usinage avec une vitesse 10⁻³ m/sec,
et
que la vitesse de solidification et le gradient de température entre le point de travail au front de solidification se trouvent, dans le GV-diagramme, dans le secteur dendritique cristallin, hors du secteur globulitique du matériel.

2. Procédé épitaxial selon l'une des revendications 1, dans lequel le matériel alimenté, qui doit être mis dans la structure monocristalline, est en forme de poudre ou en forme d'un fil.

3. Procédé épitaxial selon la revendication 1 ou 2 dans lequel le matériel alimenté est identique au matériel des structures monocristallines, des éléments, ou des pièces d'usinage ou
dans lequel le matériel alimenté est différent et montre une structure en cristal similaire au matériel du substrat.

4. Procédé épitaxial selon l'une des revendications 1 à 3, dans lequel les structures monocristallines, les éléments, ou les pièces d'usinage et/ou le matériel qui doivent être mis dans une structure monocristalline est un superalliage métallique à base de Cobalt, ou à base de Fer ou à base de Nickel, telle que CMSX-4.

5. Procédé épitaxial selon l'une des revendications 1 à 4, dans lequel les structures monocristallines, les éléments, ou les pièces d'usinage sont est préchauffé à une température de préchauffage de préférence entre une température de 800°C à 1000°C, et dans lequel la température de préchauffage est de préférence maintenue pendant la fabrication de la couche épitaxiale.

6. Procédé épitaxial selon la revendication 5 dans lequel le préchauffage du substrat est fait par induction.

7. Procédé épitaxial selon l'une des revendications 1 à 7, dans lequel la structure cristalline fabriquée est rougie au feu pour réduire les tensions internes.

8. Procédé épitaxial selon l'une des revendications 1 à 7 qui est mis en oeuvre sous gaz neutre ou sous vide, au cours duquel le gaz neutre coule dans le secteur du procédée de préférence d'une façon laminaire ou largement laminaire.

9. Procédé épitaxial selon l'une des revendications 1 à 8 pour compléter la structure monocristalline d'une ailette de turbine monocristalline usée d'une turbine à gaz ou d'un moteur d'avion.
